# EUROPÄISCHE PATENTSCHRIFT

(11) **EP 0 576 713 B1**
(45) Veröffentlichungstag und Bekanntmachung des Hinweises auf die Patenterteilung: **01.10.1997**
(21) Anmeldenummer: 92111288.4
(22) Anmeldetag: 03.07.1992
(51) Int. Cl.: H03K 17/95, B60R 16/02, B60Q 1/44, B60K 28/12

(54) **Sensorschalter für eine Betätigungseinrichtung in einem Kraftfahrzeug**
Sensor switch for an actuating device mounted on a motor vehicle
Commutateur de capteur pour un dispositif de commande monté dans un véhicule automobile

(43) Veröffentlichungstag der Anmeldung: 05.01.1994
(73) Patentinhaber: Robert Seuffer GmbH & Co., 75365 Calw (DE)
(72) Erfinder: Plener, Helmut, W-8000 München 60 (DE); Tritt, Gerhard, W-7277 Wildberg-Effringen (DE)
(74) Vertreter: Nöth, Heinz, Dipl.-Phys.

(56) Entgegenhaltungen:
- EP-A- 0 472 919
- DE-A- 1 765 593
- DE-A- 2 827 951
- DE-A- 3 519 303
- DE-B- 1 227 955
- DE-U- 8 530 900
- US-A- 4 378 504

## Beschreibung

Die Erfindung betrifft einen Sensorschalter nach dem Oberbegriff des Patentanspruches 1.

Aus der US-A-4,378,504 ist ein derartiger für die Verwendung in einem Kraftfahrzeug geeigneter Sensorschalter bekannt. Der bekannte Schalter besitzt eine an einem Kraftfahrzeug befestigbare Schaltereinheit, die in einem Schaltergehäuse eine Spule, welche eine Induktivität eines Schwingkreises bildet, aufweist. Die Schwingungseigenschaften des Schwingkreises werden durch ein beim Betätigen verstellbares und außerhalb des Schaltergehäuses angeordnetes Metallteil verändert. Ferner sind im Schaltergehäuse an den Schwingkreis angeschlossene Schaltermittel vorhanden, die in Abhängigkeit von der Änderung des Schwingverhaltens des Schwingkreises betätigt werden. Die elektronischen Bausteine der Schaltermittel sind auf einer Leiterplatte befestigt.

Ein von außen beeinflußbarer Sensorschalter mit integrierter Diagnoseeinrichtung zur Lieferung und Anzeige eines Kurzschlusses ist aus der EP-A-0 472 919 bekannt.

Aufgabe der Erfindung ist es, einen Sensorschalter der eingangs genannten Art zu schaffen, bei dem die Montage der Schaltermittel im Schaltergehäuse in einer Endstellung, die einen guten Wärmeübergang gewährleistet, erleichtert ist.

Diese Aufgabe wird erfindungsgemäß durch die kennzeichnenden Merkmale des Patentanspruches 1 gelöst.

Für einen kompakten Aufbau, durch den die Schaltereinheit als Steckereinheit mit Einschubteil und Anschlußstiften ausgebildet werden kann, ist eine Leiterplatte mit den daran befestigten elektrischen und elektronischen Bauteilen der Schaltermittel und gegebenenfalls einer Diagnoseeinrichtung zwischen dem Einschubteil und einem Spulenhalter, in welchem die zur Induktivitätsänderung des Schwingkreises mit dem Metallteil zusammenwirkende Spule untergebracht ist, angeordnet und befestigt. Leiterplatte, Einschubteil und Spulenhalter bilden hierzu eine in ein Schaltergehäuse einsetzbare Baueinheit. Bei in das Schaltergehäuse eingesetzter Anordnung dieser Baueinheit erhält man einen als Steckereinheit ausgebildeten Sensorschalter, bei dem das Einschubteil mit den Anschlußstiften aus dem Schaltergehäuse ragt.

Das Schaltergehäuse ist zur besseren Wärmeableitung metallisch ausgebildet und kann an seinem Umfang mit Kühlrippen ausgestatten sein.

Die in das Schaltergehäuse einsetzbare Baueinheit ist an dem Ende, an welchem der Spulenhalter angeordnet ist, zylindrisch ausgebildet. Bevorzugt sind zwei zylindrische Dichtflächen mit unterschiedlichen Durchmessern vorgesehen. An der Innenseite des Gehäuses sind ebenfalls zwei entsprechende unterschiedliche Durchmesser aufweisende Dichtflächen vorgesehen.

Zwischen diesen jeweilss zwei Dichtflächen an der Gehäuseinnenseite und der Außenseite des zylindrischen Spulenhalters sind zwei Dichtringe, insbesondere O-Ringe, vorgesehen, so daß in zwei unterschiedlichen Durchmessern bzw. Umfangsebenen eine Dichtwirkung erreicht wird.

Um eine verbesserte Wärmeabführung vom Halbleiterbaustein, in welchem die elektronischen Bauteile der Schaltermittel und der Diagnoseeinrichtung integriert sind, zu erreichen, wird der Halbleiterbaustein mit einer ebenen Fläche gegen eine ebenfalls ebene Fläche der Innenwand des metallischen Gehäuses angedrückt. Hierzu dient die an der Gehäuseinnenwand abgestützte Feder. Diese Andrückfeder kann so ausgebildet sein, daß sie an rampenartig ansteigenden Abstützflächen an der Gehäuseinnenseite abgestützt ist und beim Einschieben der Baueinheit in das Gehäuse eine erhöhte Druckwirkung auf den beweglich an der Leiterplatte kontaktierten und befestigten Halbleiterbaustein ausübt, so daß dieser großflächig gegen die Innenseite des metallischen Gehäuses angedrückt wird. Aufgrund der rampenartig ausgebildeten Abstützflächen an der Innenseite des Gehäuses wird das Einsetzen der Baueinheit in das Gehäuse erleichtert, so daß man eine einfache Endmontage des Schalters erreicht. Ferner werden unterschiedliche thermische Ausdehnungskoeffizienten der Bausteinmaterialien durch die insbesondere federnde Anlage des Halbleiterbausteins am Gehäuse ausgeglichen.

Anhand der Figuren wird an einem Ausführungsbeispiel die Erfindung noch näher erläutert. Es zeigt:
- Fig. 1: ein Ausführungsbeispiel für einen erfindungsgemäßen Sensorschalter in perspektivischer Explosivdarstellung der Einzelbestandteile des Schalters;
- Fig. 2: in teilweise schnittbildlicher Darstellung das Ausführungsbeispiel vor dem Einsetzen der aus Spulenhalter, Leiterplatte und Einschubteil bestehenden Baueinheit in das Schaltergehäuse;
- Fig. 3: in teilweise geschnittener Darstellung das Ausführungsbeispiel bei in das Schaltergehäuse eingesetzter Baueinheit; und
- Fig. 4: ein Schaltbild für die einzelnen Schaltungskomponenten des in den Figuren 1 bis 3 dargestellten Ausführungsbeispiels des Sensorschalters.

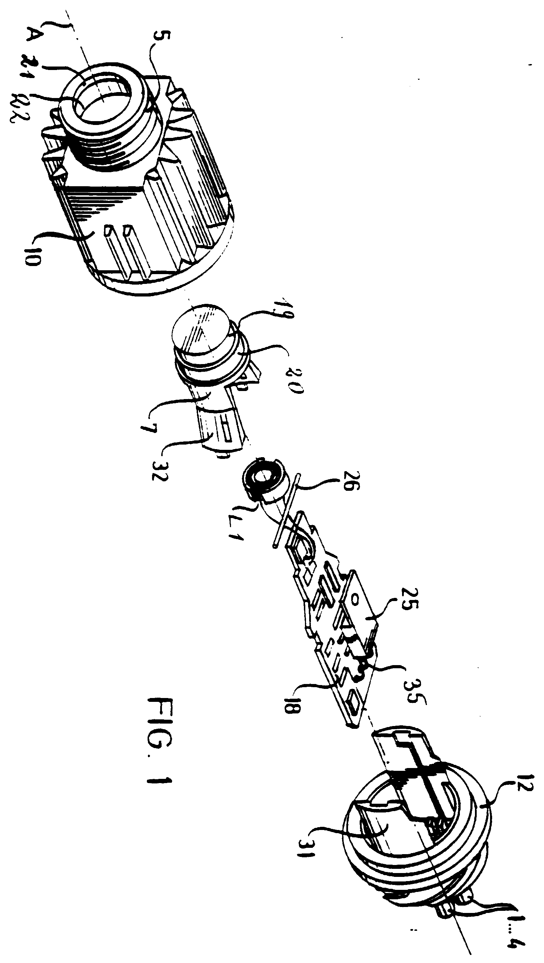

Der als Ausführungsbeispiel der Erfindung in den Figuren dargestellte Sensorschalter umfaßt ein am Kraftfahrzeug befestigbares Schaltergehäuse 10, bevorzugt aus Metall, das als Rundsteckergehäuse mit einem aus dem Gehäuse ragenden Einschubteil 12, insbesondere Bajonetteinschubteil, ausgebildet ist. Dieser Einschubteil 12 ragt im zusammengebauten Zustand an einem Ende aus dem Schaltergehäuse 10. Am anderen Ende des Schaltergehäuses 1 befindet sich ein Spulenhalter 7. In diesem beim dargestellten Ausführungsbeispiel zylindrisch ausgebildeten Spulenhalter 7 ist eine Spule L1 (Fig. 1, 2, 4) untergebracht. Die Spulenachse verläuft koaxial zur Gehäuseachse A. Ein den Spulenhalter 7 umfassendes zylindrisches Gehäuseteil mit verringertem Durchmesser besitzt ein Außengewinde 5, mit welchem das Schaltergehäuse 1 an einen nicht näher dargestellten Konstruktionsteil des Kraftfahrzeugs befestigt werden kann. Das Gehäuse besitzt an seinem Umfang sich parallel zur Achse A erstreckende Längsrippen, die radial vom Gehäuseäußeren abstehen und als Kühlrippen wirken. Mit den im Innern des Schaltergehäuses 10 untergebrachten Schaltermitteln sind Anschlüsse 1, 2, 3 und 4 vorgesehen, die stirnseitig am Einschubteil 12 vorgesehen sind.

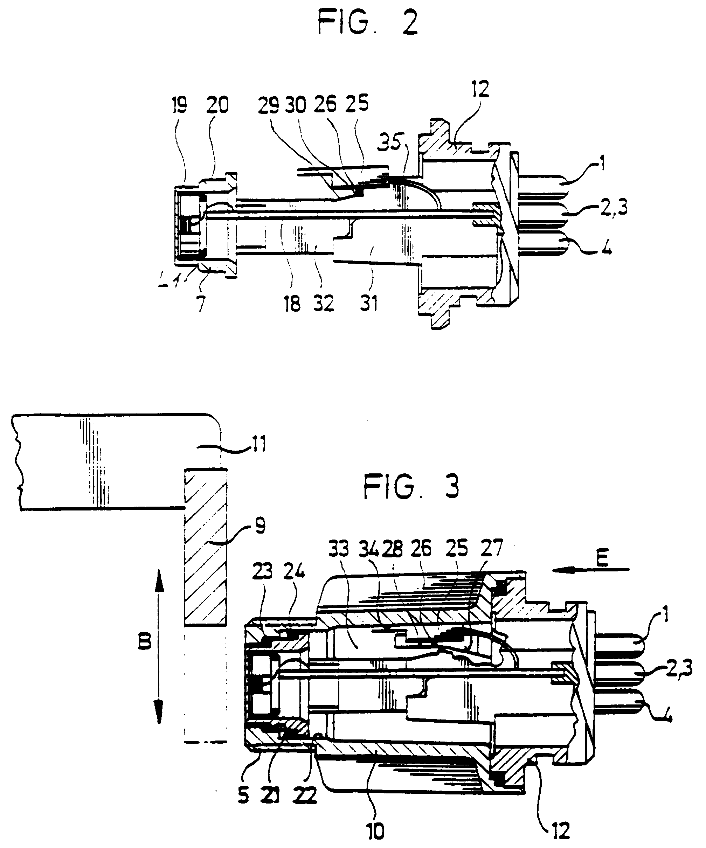

An der äußeren Stirnfläche des Spulenhalters 7 kann ein beim Ausführungsbeispiel als Metallplatte ausgebildetes Metallteil 9 (Fig. 3) zur Veränderung der von der Spule L1 vermittelten Induktivität, die im Spulenhalter 7 untergebracht ist, vorbeibewegt werden. Es kann sich hierbei um eine Hin- und Herbewegung des Metallteiles 9 handeln, wie es durch den Doppelpfeil B dargestellt ist. Das Metallteil 9 ist an einem Hebelteil 11 befestigt, der zum Fußhebelwerk eines Kraftfahrzeugs, insbesondere eines Lastkraftwagens, gehört. Das Hebelteil 11 kann beispielsweise mit dem Bremspedal oder mit dem Kupplungspedal oder auch mit dem Schaltgestänge des Schaltgetriebes verbunden sein. Wenn das Metallteil 9 vor die Stirnseite des Spulenhalters 7, d.h. vor die Spule L1, gebracht und von dort wieder entfernt wird, ändert sich die Induktivität, welche von der Spule L1 erzeugt wird.

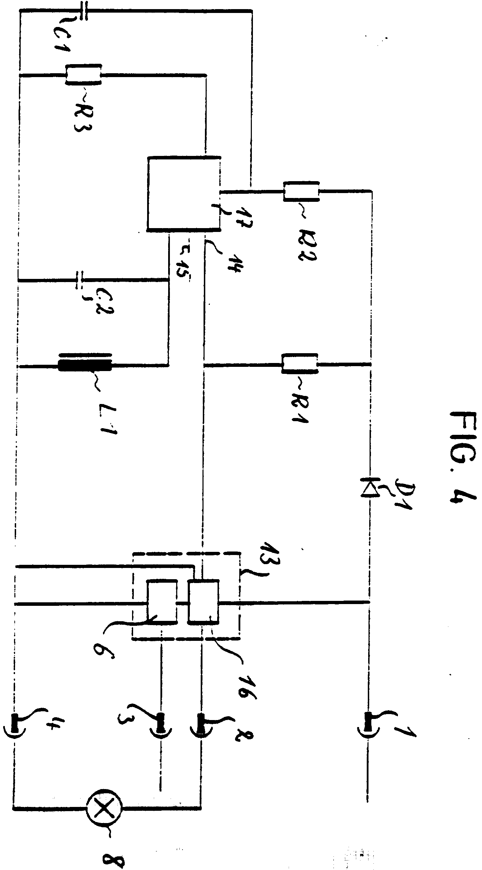

Wie die Fig. 4 zeigt, ist die Spule L1 Bestandteil eines Schwingkreises, zu welchem ein Kondensator C2 gehört. Dieser Schwingkreis ist an eine einen Oszillator enthaltende Signalverarbeitungseinrichtung 17 angeschlossen, welche Bestandteil eines integrierten Halbleiterbausteins 25 (Fig. 1-3) sein kann. Der Schwingkreis und die Signalverarbeitungsschaltung bilden einen Generator, dessen Amplitude z.B. durch Dämpfung und/oder dessen Frequenz durch die Bewegung des Metallteils veränderbar sind bzw. ist, wie noch erläutert wird. Die Signalverarbeitungseinrichtung 17 besitzt zwei Ausgänge, nämlich einen Arbeitsausgang 14 und einen Ruheausgang 15. Wenn das Metallteil 9 in der Fig. 3 seine untere Stellung einnimmt, in welcher es der Spule L1 unmittelbar gegenüberliegt, wird die Induktivität des Schwingkreises (L1, C2) geändert. Dies führt zu einer Amplituden- und/oder Frequenzänderung des Oszillators der Signalverarbeitungseinrichtung 17. In Abhängigkeit hiervon wird der Arbeitsausgang 14 der Signalverarbeitungseinrichtung 17 aktiviert (Fig. 4).

Wenn das Metallteil 9 in der Fig. 3 die untere Position einnimmt, bedeutet dies, daß ein mit dem Hebelteil 11 verbundenes nicht näher dargestelltes Bremspedal oder anderes zu überwachendes Fahrzeugteil betätigt ist. Der Arbeitsausgang 14 der Signalverarbeitungseinrichtung 17 steuert ein entsprechendes Steuerteil, beispielsweise ein Gate eines Transistors, einer in einem Leistungs-IC 13 integrierten Transistorschaltung 16 an, wie es in Figur 4 dargestellt ist. Hierdurch kann auch eine ebenfalls im Leistungs-IC 13 integrierte Diagnoseeinrichtung 6 für die Überwachung des Stromkreises eines zu überwachenden Anzeigemittels, beispielsweise der Bremslichtanlage 8, durch ein Ausgangssignal über den Anschluß 2 eingeschaltet werden. Hierbei wird festgestellt, ob in dem Laststromkreis der Bremslichtanlage zu viel Strom oder zu wenig Strom fließt. Diese Diagnose kann beispielsweise mit Hilfe einer Spannungsabfallmessung und Vergleich des gemessenen Spannungsabfalls mit einem Sollwert durchgeführt werden. Wenn Abweichungen vom Sollwert in die eine oder andere Richtung von der Diagnoseinrichtung 6 festgestellt werden, kann infolge eines Ausgangssignals über den Anschluß 3 dies durch ein Alarmzeichen, beispielsweise durch eine Leuchtanzeige am Armaturenbrett oder Bordüberwachungssystem des Kraftfahrzeugs, kenntlich gemacht werden.

Mit dieser Diagnoseinrichtung 6 kann natürlich auch die Hauptfunktion überprüft werden, ob die Anzeigeeinrichtung, insbesondere die Anzeigelampe 8, eingeschaltet oder ausgeschaltet ist. Ferner kann die richtige Polung der Anzeigeeinrichtung durch Verwendung einer Diodenschaltung in der Diagnoseeinrichtung 6 überwacht werden. Ferner ist es möglich, beispielsweise mit Hilfe von Halbleiterwiderstandsveränderung, in der Diagnoseeinrichtung 6 den thermischen Betriebszustand eines Bauteils oder einer Bauteilgruppe zu überwachen. Hierzu ist ein thermischer Wärmeübergang zwischen den integrierten Bausteinen der Schaltereinrichtung 16, welche auch hohe Leistungsausgänge, z.B. bis zu 160W schalten kann, und der Diagnoseeinrichtung 6 vorhanden.

In der in Fig. 4 dargestellten Schaltung ist ferner eine Diode D1 vorgesehen zur Gleichstromversorgung der verwendeten Bauteile über den Anschluß 1. Ferner enthält diese Schaltung Betriebswiderstände R1, R2 und R3. Ein Kondensator C1 hat eine Filterfunktion und bildet einen Schwingungsschutz gegen hohe Frequenzen aus der Umgebung des Sensorschalters.

Das in der Fig. 3 gezeigte Metallteil 9 kann auch mit der Handbremse eines Kraftfahrzeugs verbunden sein. Wenn das Metallteil 9 mit der Handbremse eines Lastkraftwagens mit abkippbarem Fahrergehäuse gekoppelt ist, kann in Zusammenwirkung mit der Signalverarbeitungseinrichtung 17, der Transistorschaltung 16 und gegebenenfalls der Diagnoseinrichtung 6 eine Sperre angesteuert werden, durch die verhindert wird, daß bei nicht angezogener Handbremse das Fahrergehäuse gekippt wird. Auch kann durch die Sperreeinrichtung verhindert werden, daß bei nicht angezogener Handbremse sich die Tür des Lastkraftwagens öffnet, so daß der Fahrer gezwungen ist, die Handbremse anzuziehen, wenn er den Lastkraftwagen verläßt bzw. wenn er das Fahrergehäuse abkippen will. Desgleichen ist es möglich, das Metallteil 9 mit der jeweiligen Tür eines Kraftfahrzeugs zu koppeln, so daß in Zusammenwirkung mit der Signalverarbeitungseinrichtung 17, der Transistorschaltung 16 und gegebenenfalls der Diagnoseeinrichtung 6 ein Starten des Fahrbetriebs verhindert wird, solange eine Tür des Kraftfahrzeugs nicht einwandfrei geschlossen ist.

Wie aus den Figuren 1 bis 3 zu ersehen ist, beinhaltet der Sensorschalter eine Schaltereinheit, die aus dem Schaltergehäuse 10, dem Spulenhalter 7, dem Einschubteil 12 mit vier als Anschlußstifte ausgebildeten Anschlüssen 1 bis 4 sowie eine gedruckte Leiterplatte 18, auf welcher die elektrischen und elektronischen Bestandteile des Schalters, beispielsweise durch Löten, verschaltet und befestigt sind. Diese Schaltereinheit ist als Steckereinheit, insbesondere Rundsteckereinheit, ausgebildet.

Wie die Fig. 2 zeigt, sind die Leiterplatte 18, der Spulenhalt er 7 und das Einschubteil 12 mit den vier Anschlüssen 1 bis 4 als eine Baueinheit ausgebildet, die, wie in Fig. 3 dargestellt ist, in das Schaltergehäuse 10 eingesetzt werden kann. Sowohl das Einschubteil 12 als auch der Spulenhalter 7 besitzen angeformte Rahmenteile 31, 32, welche die Leiterplatte 18 beidseitig umfassen. Im Bereich der freien Enden der angeformten Rahmenteile 31, 32 können der Spulenhalter 7 und das Einschubteil 12 miteinander verbunden sein, wobei durch diese seitlichen Rahmenteile die Leiterplatte 18 gehalten wird. Auf diese Weise wird die in das Gehäuse 10 einschiebbare Baueinheit gebildet. Natürlich ist es auch möglich, daß der Spulenhalter 7, das Einschubteil 12 und die seitlichen Rahmenteile 31, 32 aus einem Stück gefertigt sind und als Haltevorrichtung für die eingesetzte Leiterplatte 18 dienen. Der Spulenhalter 7, das Einschubteil 12 und die beiden Rahmenteile 31, 32 können aus einem geeigneten Kunststoff, beispielsweise Ultramid, gefertigt sein.

Wenn die aus Leiterplatte 18, Einschubteil 12 und Spulenhalter 7 bestehende Baueinheit in das Gehäuse 10 eingesetzt ist (Fig. 3), befindet sich der zylindrisch geformte Spulenhalter 7 in einem das Außengewinde 5 aufweisenden zylindrischen Gehäuseteil mit gegenüber dem übrigen Gehäuse verringertem Durchmesser. Die Stirnflächen des Gehäuseteils und der Spulenhalter 7 liegen in der gleichen Ebene und bilden eine ebene Fläche. Vor diese Fläche kann das Metallteil 9 zur Änderung der Induktivität des Schwingkreises, z.B. beim Betätigen des zu überwachenden Kraftfahrzeugteils, bewegt werden und in die in der Fig. 3 gezeigte Ruhestellung wieder zurückgebracht werden, wenn der entsprechende Kraftfahrzeugteil nicht betätigt wird. In dieser Stellung ist der Ruhekontakt 15 der Signalverarbeitungseinrichtung 17 (Fig. 4) aktiviert.

Wie die Fig. 3 ferner zeigt, ragt das Einschubteil 12, welches ein Bajonetteinschubteil oder ein anderes genormtes Einschubteil sein kann, aus der dem Spulenhalter 7 entgegengesetzt liegenden Gehäusestirnseite heraus. Das Einschubteil 12 kann mit einer entsprechenden Steckerbuchse zur elektrischen Kontaktierung mittels der Anschlüsse 1 bis 4 mit einer Versorgungsspannungsquelle, entsprechenden Anzeigemitteln, beispielsweise Anzeigelampe 8, Bremslichtern und dgl. oder auch mit Anzeigeeinrichtungen am Armaturenbrett und dort Überwachungssystem des Kraftfahrzeugs, elektrisch verbunden werden.

Der Spulenhalter 7 ist als zylindrischer Gehäuseteil mit äußeren Dichtflächen 19 und 20, die unterschiedliche Durchmesser aufweisen, ausgebildet. An der Innenseite des Schaltergehäuses 10, insbesondere im Bereich des Gehäuseteils mit dem verringertem Durchmesser und dem Außengewinde 5 sind ebenfalls zwei Dichtflächen 21 und 22 vorgesehen mit unterschiedlichen Durchmessern. Zwischen den Dichtflächen 21, 22 des Gehäuses 10 und den Dichtflächen 19, 20 am Spulenhalter 7 sind Dichtringe 23 und 24, insbesondere O-Ringe, angeordnet. Hierdurch wird eine doppelte Sicherheit bei der Abdichtung des Gehäuseinnenraums, insbesondere gegen Verschmutzung und Feuchtigkeit gewährleistet.

Wie schon ausgeführt, können die elektronischen Bauteile und insbesondere auch das Leistungs-IC der Schaltermittel in einem Halbleiterbaustein 25 angeordnet sein. Dieser Halbleiterbaustein 25 ist beweglich, beispielsweise mit Hilfe biegbarer Anschlußstifte 35, an der Leiterplatte 18 kontaktiert und befestigt. Da das Leistungs-IC des Halbleiterbausteins 25 eine hohe Ausgangsleistung mit bis zu 160W schalten kann, ist es erforderlich, für eine geeignete Kühlung bzw. Wärmeabfuhr zu sorgen. Hierzu kann beim dargestellten Ausführungsbeispiel der Halbleiterbaustein 25 mit Hilfe einer Feder 26 gegen die Innenwand des Schaltergehäuses 10 angedrückt werden Die Feder 26 ist beim dargestellten Ausführungsbeispiel als stabförmige Feder (Fig. 1), beispielsweise als Federdraht, ausgebildet. Die beiden Enden der stabförmigen Feder 26 sind in rampenartig ansteigenden Abstützflächen 27, 28 an der Innenseite beidseitig des Schaltergehäuses 10 abgestützt. Der mittlere Teil der Feder 26 drückt gegen den Halbleiterbaustein 25, so daß dieser flächig mit gutem Wärmekontakt an der Innenwand des Schaltergehäuses 10 anliegt. Wie insbesondere die Fig. 3 zeigt, sind die Abstützflächen 27 und 28 an der Innenseite des Gehäuses 10 in Einschubrichtung (Pfeil E) ansteigend an beiden Gehäuseseiten ausgebildet und verlaufen dann in einen etwa parallel zur Längsaches A verlaufenden Abstützflächenteil, auf welchem die beiden Enden der Feder 26 im eingebauten Zustand aufliegen. Durch die so ansteigenden Abstützflächen wird ein behinderungsfreies Einsetzen der aus dem Spulenhalter 7, der Leiterplatte 18 und dem Einschubteil 12 bestehenden Baueinheit in das Schaltergehäuse 10 gewährleistet. Ferner wird gewährleistet, daß der Halbleiterbaustein 25 mit einer großen Berührungsfläche an der ebenfalls in diesem Bereich eben ausgebildeten Innenwand des Gehäuses 10 anliegt, so daß ein guter Wärmeübergang gewährleistet ist. Diese Berührungsfläche an der Gehäuseinnenseite ist mit der Bezugsziffer 34 bezeichnet. Diese Berührungsfläche 34 an der Gehäuseinnenseite kann entgegengesetzt zu den Abstützflächen 27, 28 geneigt sein, so daß ein ungehindertes Einschieben der Baueinheit in die Einschubbahn 33 im Gehäuse 10 und eine flächenhafte Berührung zwischen Halbleiterbaustein 25 und Gehäuse 10 im eingebauten Zustand gewährleistet wird.

Die beiden Abstützflächen 27 und 28 für die Federenden an der Gehäuseinnenseite können als Ausnehmungen an der Gehäuseinnenwand ausgebildet sein.

Wie insbesondere aus der Fig. 2 zu ersehen ist, sind die beiden Enden der Feder 26 im nicht eingebauten Zustand der Baueinheit an zwei ansteigenden Abstützflächen 29 und 30 der Baueinheit abgestützt. Diese Abstützflächen 29 und 30 steigen in entgegengesetzter Richtung zur Einschubrichtung (Pfeil E) bzw. in entgegengesetzter Richtung zu den beiden Abstützflächen 27 und 28 an der Gehäuseinnenwand des Gehäuses 10 an. Auf diese Weise wird gewährleistet, daß vor dem Einschieben der Baueinheit in das Gehäuse 10 der Halbleiterbaustein 25 in eine möglichst niedrige Position gebracht ist, wobei die Feder zwischen der Unterseite des Halbleiterbausteins und den Abstützflächen 29 und 30 gehalten ist. Hierdurch erhält die Baueinheit eine Höhe, welche dem größten Durchmesser des Einschubteils 12 entspricht, d.h. ihre minimale Bauhöhe, so daß das Einschieben der Baueinheit in die Einschubbahn 33 des Gehäuses behinderungsfrei erreicht wird.

Nach dem Einbauen wird aufgrund der in Einschubrichtung ansteigenden Abstützflächen 27, 28 am Gehäuse 10 die Feder und damit der Halbleiterbaustein 25 angehoben, so daß der oben schon erläuterte Wärmekontakt zwischen Halbleiterbaustein und metallischem Gehäuse 10 erreicht wird.

Beim dargestellten Ausführungsbeispiel können die schräg ansteigenden Abstützflächen 29 und 30 an den seitlichen Rahmenteilen 32, welche die Verbindung zwischen dem Spulenhalter 7 und dem Einschubteil 12 sowie die seitliche Abstützung der Leiterplatte 18 gewährleisten, vorgesehen sein.

## Patentansprüche

1. Sensorschalter für eine Betätigungseinrichtung eines Kraftfahrzeuges, mit einer am Kraftfahrzeug befestigbaren Schaltereinheit, die in einem Schaltergehäuse (10) eine Spule (L1), welche eine Induktivität eines Schwingkreises (L1,C2) bildet, dessen Schwingungseigenschaften durch ein beim Betätigen der Betätigungseinrichtung verstellbares und außerhalb des Schaltergehäuses (10) angeordnetes Metallteil (9) veränderbar sind und an den Schwingkreis (L1,C2) angeschlossene Schaltermittel (16), welche in Abhängigkeit von einer Änderung des Schwingverhaltens des Schwingkreises (L1,C2) betätigt sind, aufweist,
dadurch gekennzeichnet, daß
die Schaltermittel (16) in einem in das Schaltergehäuse einschiebbaren Halbleiterbaustein (25) integriert sind und daß eine Andrückfeder (26) vorgesehen ist, welche am Schaltergehäuse (10) an in Einschubrichtung des Halbleiterbausteins (25) rampenartig ansteigenden Abstützflächen (27,28) so abgestützt ist, daß beim Einschieben des Halbleiterbausteins (25) in das Schaltergehäuse (10) die Andrüchfeder angehoben und damit der Halbleiterbaustein (25) gegen die Innenseite des Schaltergehäuses (10) angedrückt wird.

2. Sensorschalter nach Anspruch 1, dadurch gekennzeichnet, daß die Feder (26) als Stabfeder ausgebildet ist, deren beide Enden an zwei in Einschubrichtung ansteigende rampenartige Abstützflächen (27,28) an der Innenseite des Schaltergehäuses (10) abgestützt sind und welche mit ihrem mittleren Federteil gegen den Halbleiterbaustein (25) gedrückt ist.

3. Sensorschalter nach Anspruch 2, dadurch gekennzeichnet, daß eine Baueinheit (7,12,18), welche einen die Spule (L1) aufweisenden Spulenhalter (7), eine den Halbleiterbaustein (25) aufweisende Leiterplatte (18) und ein Anschlüsse (1 bis 4) aufweisendes Einschubteil (12) enthält, zwei in entgegengesetzter Richtung zu den beiden Abstützflächen (27,28) am Schaltergehäuse (10) ansteigende Abstützflächen (29,30) für die beiden Enden der Feder (26) bei außerhalb des Schaltergehäuses (10) angeordneter Baueinheit (7,12,18) aufweist.

4. Sensorschalter nach Anspruch 1 oder 2, dadurch gekennzeichnet, daß die Abstützflächen (27,28) am Schaltergehäuse (10) als Ausnehmungen an der Gehäuseinnenwand ausgebildet sind.

5. Sensorschalter nach Anspruch 3, dadurch gekennzeichnet, daß die Abstützflächen (29,30) an der Baueinheit (7,12,18) an Rahmenteilen (31,32), welche die Leiterplatte (18) beidseitig umfassen, angeformt sind.

6. Sensorschalter nach Anspruch 1, dadurch gekennzeichnet, daß eine Andrückfläche an der Innenseite des Schaltergehäuses (10), gegen welche der Halbleiterbaustein (25) mit einer ebenen Berührungsfläche (34) angedrückt ist, eben ausgebildet und entgegengesetzt zu den rampenartigen ansteigenden Abstützflächen (27,28) am Schaltergehäuse (10) geneigt ist.

7. Sensorschalter nach Anspruch 3 oder 5, dadurch gekennzeichnet, daß der Halbleiterbaustein (25) an der Leiterplatte (18) beweglich befestigt ist.

8. Sensorschalter nach Anspruch 1, dadurch gekennzeichnet, daß die im Halbleiterbaustein integrierten Schaltermittel (16) einen hohen Leistungsausgang bis zu 160 W schalten.

9. Sensorschalter nach Anspruch 1 oder 8, dadurch gekennzeichnet, daß die als Transistorschaltung ausgebildeten Schaltermittel (16) und eine mit den Schaltermitteln (16) verbundene Diagnoseeinrichtung (6) als Leistungs-lC (13) ausgebildet sind, das in den Halbleiterbaustein (25) integriert ist.

10. Sensorschalter nach Anspruch 3, dadurch gekennzeichnet, daß die in das Schaltergehäuse (10) einsetzbare Baueinheit (7,12,18) an dem Ende, an welchen der Spulenhalter (7) angeordnet ist, zylindrisch mit zwei zylindrischen unterschiedlichen Durchmesser aufweisenden Dichtflächen (19,20) ausgebildet ist, daß an der Innenseite des Schaltergehäuses (10) zwei entsprechende unterschiedliche Durchmesser aufweisende Dichtflächen (21,27) vorgesehen sind und daß zwischen den Dichtflächen (19,20,21) Dichtringe (23,24) angeordnet sind.

## Claims

1. A sensor switch for an actuating device of a motor vehicle, comprising a switch unit which can be fixed to the motor vehicle and which has in a switch housing (10) a coil (L1) forming an inductance of a resonant circuit (L1, C2) whose oscillation properties are variable by a metal portion (9) arranged outside the switch housing (10) and displaceable upon actuation of the actuating device, and switch means (16) which are connected to the resonant circuit (L1, C2) and which are actuated in dependence on a change in the oscillation characteristics of the resonant circuit (L1, C2),
characterised in that
the switch means (16) are integrated in a semiconductor component (25) which can be inserted into the switch housing and that there is provided a contact pressure spring (26) which is so supported on the switch housing (10) at support surfaces (27, 28) that rise ramp-like in the direction of insertion of the semiconductor component (25) that when the semiconductor component (25) is inserted into the switch housing (10) the contact pressure spring is lifted and thus the semiconductor component (25) is pressed against the inside of the switch housing (10).

2. A sensor switch according to claim 1 characterised in that the spring (26) is in the form of a bar spring, the two ends of which are supported against ramp-like support surfaces (27) rising in the insertion direction at the inside of the switch housing (10), and which is pressed with its central spring portion against the semiconductor component (25).

3. A sensor switch according to claim 2 characterised in that a unit (7, 12, 18) which includes a coil holder (7) having the coil (L1), a printed circuit board (18) having the semiconductor component (25), and an insertion portion (12) having connections (1 to 4) has support surfaces (29, 30) which rise in the opposite direction to the two support surfaces (27, 28) on the switch housing (10), for the two ends of the spring (26) when the unit (7, 12, 18) is arranged outside the switch housing (10).

4. A sensor switch according to claim 1 or claim 2 characterised in that the support surfaces (27, 28) on the switch housing (10) are in the form of openings at the inside wall surface of the housing.

5. A sensor switch according to claim 3 characterised in that the support surfaces (29, 30) are formed on the unit (7, 12, 18) on frame portions (31, 32) which embrace the printed circuit board (18) on both sides.

6. A sensor switch according to claim 1 characterised in that a contact pressure surface at the inside of the switch housing (10), against which surface the semiconductor component (25) is pressed with a flat contact surface (34), is flat and is inclined in opposite relationship to the ramp-like rising support surfaces (27, 28) on the switch housing (10).

7. A sensor switch according to claim 3 or claim 5 characterised in that the semiconductor component (25) is movably secured to the printed circuit board (18).

8. A sensor switch according to claim 1 characterised in that the switch means (16) which are integrated in the semiconductor component switch a high power output of up to 160 W.

9. A sensor switch according to claim 1 or claim 8 characterised in that the switch means (16) which are in the form of a transistor circuit and a diagnosis means (6) which is connected to the switch means (16) are in the form of a power-IC (13) which is integrated into the semiconductor component (25).

10. A sensor switch according to claim 3 characterised in that at the end at which the coil holder (7) is arranged, the unit (7, 12, 18) which can be fitted into the switch housing (10) is cylindrical with two sealing surfaces (19) of different diameters, that two sealing surfaces (21, 27) of corresponding different diameters are provided at the inside of the switch housing (10), and that sealing rings (23, 24) are arranged between the sealing surfaces (19, 20, 21).

## Revendications

1. Commutateur de capteur pour un dispositif de commande d'un véhicule automobile, avec une unité de commutation qui peut être fixée sur le véhicule et qui présente, dans une boîte (10), une bobine (L1) qui forme une inductance d'un circuit oscillant (L1, C2), dont les propriétés oscillatoires sont modifiables par une pièce métallique (9), mobile lors de l'actionnement du dispositif de commande et disposée à l'extérieur de la boîte (10), et avec des moyens de commutation (16), reliés au circuit oscillant (L1, C2) et commandés en fonction d'une modification du comportement oscillatoire du circuit oscillant (L1, C2), caractérisé en ce que les moyens de commutation (16) sont intégrés à un module à semi-conducteur (25), insérable dans la boîte, et en ce qu'un ressort de pression (26) est prévu, ce ressort s'appuyant, dans la boîte (10), sur des surfaces d'appui (27, 28) ascendantes en rampe dans le sens d'insertion du module (25), de sorte que, lors de l'insertion du module à semi-conducteur (25) dans la boîte (10), le ressort de pression est relevé et le module (25) est donc pressé contre la face interne de la boîte (10).

2. Commutateur de capteur suivant la revendication 1, caractérisé en ce que le ressort (26) est réalisé sous forme de ressort en barre, dont les deux extrémités s'appuient sur des surfaces (27, 28), ascendantes en rampe dans le sens d'insertion et prévues sur la face interne de la boîte (10), et qui est pressé par sa partie centrale contre le module à semi-conducteur (25).

3. Commutateur de capteur suivant la revendication 2, caractérisé en ce qu'une unité modulaire (7, 12, 18), qui comporte un support de bobine (7) avec une bobine (L1), une carte imprimée (18) munie du module à semi-conducteur (25), et un élément insérable (12) doté de jonctions (1 à 4), présente, pour les deux extrémités du ressort (26), deux surfaces d'appui (29, 30) ascendantes en sens contraire de celui des deux surfaces d'appui (27, 28) prévues sur la boîte (10), lorsque l'unité modulaire (7, 12, 18) est disposée à l'extérieur de la boîte (10).

4. Commutateur de capteur suivant l'une des revendications 1 et 2, caractérisé en ce que les surfaces d'appui (27, 28), prévues sur la boîte (10), sont réalisées sous forme d'évidements sur la paroi interne de la boîte.

5. Commutateur de capteur suivant la revendication 3, caractérisé en ce que les surfaces d'appui (29, 30), prévues sur l'unité modulaire (7, 12, 18), sont conformées sur des parties de cadre (31, 32), qui enveloppent de part et d'autre la carte imprimée (18).

6. Commutateur de capteur suivant la revendication 1, caractérisé en ce qu'une surface d'appui, prévue sur la face interne de la boîte (10) et contre laquelle est pressé le module à semi-conducteur (25) par une surface de contact plane (34), a une réalisation plane et est inclinée en sens contraire de celui des surfaces d'appui (27, 28) ascendantes en rampe, prévues sur la boîte (10).

7. Commutateur de capteur suivant l'une des revendications 3 et 5, caractérisé en ce que le module à semi-conducteur (25) a une fixation mobile sur la carte imprimée.

8. Commutateur de capteur suivant la revendication 1, caractérisé en ce que les moyens de commutation (16), intégrés au module à semi-conducteur, commutent une sortie de puissance élevée, jusqu'à 160 W.

9. Commutateur de capteur suivant l'une des revendications 1 et 8, caractérisé en ce que les moyens de commutation (16), réalisés sous forme de circuit transistorisé, et un appareil de diagnostic (6), relié aux moyens de commutation (16), sont réalisés sous forme de CI de puissance intégré au module à semi-conducteur (25).

10. Commutateur de capteur suivant la revendication 3, caractérisé en ce que l'unité modulaire (7, 12, 18) logeable dans la boîte (10) a une réalisation cylindrique sur l'extrémité, sur laquelle est disposé le support de bobine (7), avec deux portées de joint (19, 20) de diamètres différents, en ce que deux portées de joint correspondantes (21, 27) de diamètres différents sont prévues sur la face interne de la boîte (10), et en ce que des bagues d'étanchéité (23, 24) sont disposées entre les portées de joint (19, 20, 21).
